(19) **Europäisches Patentamt**

**European Patent Office**

**Office européen des brevets**

(11) **EP 1 262 027 B1**

(12) **EUROPEAN PATENT SPECIFICATION**

(45) Date of publication and mention
of the grant of the patent:
**31.08.2005 Bulletin 2005/35**

(51) Int Cl.⁷: $H03M\ 13/35$, $H03M\ 7/36$

(21) Application number: **01907055.6**

(22) Date of filing: **07.02.2001**

(86) International application number:
**PCT/US2001/003888**

(87) International publication number:
**WO 2001/058024 (09.08.2001 Gazette 2001/32)**

(54) **METHOD OF DIFFERENTIAL CODING AND MODULATION**

VERFAHREN ZUR DIFFERENZIELLEN KODIERUNG UND MODULATION

PROCEDE DE CODAGE DIFFERENTIEL ET DE MODULATION

(84) Designated Contracting States:
**AT BE CH CY DE DK ES FI FR GB GR IE IT LI LU
MC NL PT SE TR**

(30) Priority: **07.02.2000 US 180757 P**

(43) Date of publication of application:
**04.12.2002 Bulletin 2002/49**

(73) Proprietor: **Ericsson Inc.
Plano, TX 75024 (US)**

(72) Inventor: **KHAYRALLAH, Ali, S.
Apex, NC 27502 (US)**

(74) Representative:
**Holmberg, Nils Anders Patrik et al
Dr Ludwig Brann Patentbyra AB
P.O. Box 17192
104 62 Stockholm (SE)**

(56) References cited:
**US-A- 5 673 291          US-A- 5 757 821
US-A- 5 850 403**

**Description**

BACKGROUND OF THE INVENTION

The present invention relates generally to wireless communication systems and, more particularly, to a wireless communication system that uses differential coding in combination with a multi-pass demodulation receiver.

The purpose of any communication system is to reliably transmit information from a source to a destination over a communication channel. In a typical communication system, an information signal is error coded to protect the information signal from errors that may occur during transmission. The coded information signal is then modulated onto a carrier for transmission from the source to the destination. The transmitted signal may be corrupted by adverse effects of the communication channel, such as dispersion, interference, fading, and noise. At the destination, the original information signal must be recovered from the received signal. The received signal is demodulated to produce an estimate of the transmitted signal, which estimate is then decoded to produce an estimate of the original information signal. Ideally, the estimate of the information signal will be an exact replica of the original information signal.

In conventional communication systems, coding is performed separately from modulation in the transmitter. Likewise, demodulation and decoding are performed separately in the receiver. This separation allows reasonable complexity in the receiver, particularly when interleaving is used in the system. When interleaving is used, the output of the demodulator is first de-interleaved and then fed to the decoder. In most systems, the demodulator produces some form of bit reliability information which may be exploited by the decoder to improve performance.

It is known from information theory that the optimal receiver performs demodulation and decoding jointly. In general, joint demodulation and decoding greatly increases the complexity of the receiver, especially when interleaving is used. As an alternative to joint demodulation and decoding, it is known to use feedback from the decoder to the demodulator to improve performance of the receiver with reasonable receiver complexity. This is the idea behind multi-pass demodulation.

US A 5,757,821 merely discloses an example of a system and method for using unequal error protection (UEP).

US A 5,673,291 discloses an example of a multi-pass receiver. i.e. the receiver performance is improved by combining the demodulation and the decoding processes. The received signal is initially demodulated and then decoded in conventional fashion. The decoded signal (bits) is (are) then re-encoded and selected ones of the re-encoded bits are fed back to the demodulator, and demodulated a second time (i.e. a higher order modulation).

The objective problem of the present invention is to improve the performance when using a multi-pass receiver.

BRIEF SUMMARY OF THE INVENTION

The present invention relates to a method and apparatus for coding and modulating information at a transmitter and a corresponding method and apparatus for decoding and demodulating a received signal at a receiver. According to the present invention, an input sequence comprising a plurality of input symbols is differentially coded to generate a transmit sequence comprising a plurality of transmit symbols. Differential coding is carried out by differentially coding selected bits of an input symbol with respect to one or more bits of a previous symbol to generate a transmit symbol with differentially coded bits. Some transmit symbols may contain a mixture of differentially coded bits and non-differentially coded bits. Some transmit symbols may contain exclusively differentially coded bits. Other transmit symbols may contain exclusively non-differentially coded bits. Following differential coding, the transmit symbols are input to a modulator which modulates a carrier with the transmit sequence.

At the receiver, the received signal is demodulated to produce a received sequence comprising a plurality of received symbols. Certain ones of the received symbols may include differentially coded bits, which are differentially decoded to produce an estimate of the original input sequence. If channel coding is used, the estimate of the input sequence is passed to a channel decoder, which produces an estimate of the originally-transmitted information sequence. The demodulator may be a multi-pass demodulator which uses re-encoded bits fed back from the decoder as pilot bits in second pass demodulation.

BRIEF DESCRIPTION OF THE DRAWINGS

Figure 1 is a functional block diagram of a communication system.
Figure 2 is a functional block diagram of a multi-pass demodulator.
Figure 3 is a functional block diagram of a transmitter according to the present invention.
Figure 4 is a functional block diagram of a receiver according to the present invention.
Figure 5 is a diagram of an eight-state equalizer trellis used in one embodiment of the present invention.
Figure 6 is a diagram of a two-state equalizer trellis used in one embodiment of the present invention.

DETAILED DESCRIPTION OF THE INVENTION

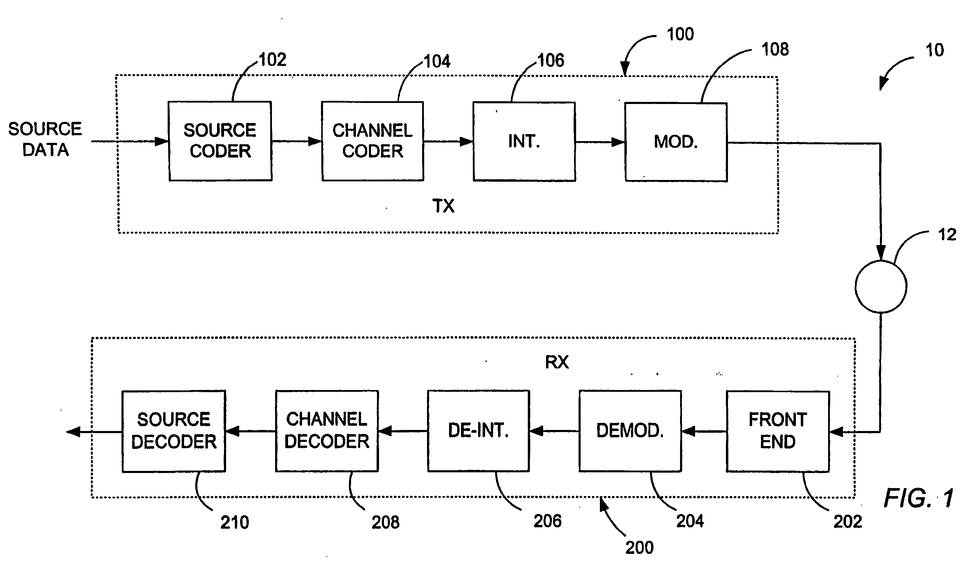

Figure 1 illustrates a digital communication system, generally indicated by the numeral 10. The digital communication system 10 comprises a transmitter 100 and a receiver 200 which are coupled by a communications channel 12. The basic function of the communication system 10 is to transmit and information sequence from the transmitter 100 to the receiver 200 with as few errors as possible.

The transmitter 100 includes a source coder 102, a channel coder 104, optional interleaver 106, and a modulator 108. An information source provides a source data stream that is to be ultimately conveyed to the receiver 200. The source data stream is assumed to be in a digitized format and is passed directly to the source coder 102. The source coder 102 removes redundancy or randomizes the source data stream, producing an information sequence which has been optimized for maximum information content. The information sequence from the source coder 102 is passed to the channel coder 104.

Channel coder 104 is designed to introduce an element of redundancy into the information sequence output by the source coder 102, to generate a coded sequence. While initially appearing at odds with the function of the source coder 102, in reality, the redundancy added by the channel coder 104 serves to enhance the error correction capability of the communication system 10. By introducing redundant information into the information sequence in a controlled manner, a receiver 200 can detect and correct bit errors that may occur during transmission by making use of the redundant information and it's *a priori* knowledge of the codes used at the transmitter 100. Channel coder 104 may apply error coding to selected bits, referred to herein as protected bits. Bits not protected by error coding are referred to herein as unprotected bits. Further, protected bits may fall into two or more classes, with certain classes of bits receiving greater error protection than other classes.

Interleaver 106 permutes the ordering of the coded bits output from the channel coder 104 in a deterministic manner. It takes coded bits at an input and produces a sequence of identical bits at an output, but in a different order. Thus, the interleaver spreads bits in time. In many communication systems, some source bits are more important than other source bits. For example, a speech coder typically outputs several important bits, referred to as Class I bits, in succession. It is the function of the interleaver 106 to spread the important bits in time to protect against a deep fade, where an entire block of bits may be lost or corrupted. Interleaving effectively spreads the important bits in time so that even in a deep fade, a sufficient number of the important bits will be successfully transmitted to the receiver 200 to maintain a desired signal quality standard.

Modulator 108 receives the interleaved output from the interleaver 106 and generates waveforms that both suit the physical nature of the channel 12 and can be efficiently transmitted over the channel 12. The set of possible signal waveforms output from the modulator 108 is referred to as the signal constellation. The bits output from interleaver 106 are grouped to form symbols, which are then mapped to points on the signal constellation. For example, the input bits to the demodulator 106 may be grouped into a sequence of symbols comprising three bits each, with each bit having two possible values. In this example, the signal constellation would have eight points corresponding to the eight possible combinations of three bits. The signal constellation or modulation scheme is typically selected with regard to either simplification of the communication system, optimal detection performance, power requirements, or bandwidth availability. Typical signal constellations used in digital communication systems include 16-QAM, 8-PSK, 4-PSK, and GMSK. The output of modulator 108 is a transmit signal that is amplified and transmitted over the communication channel 12 to the receiver 200.

The basic function of the receiver 200 is to reconstruct the information sequence transmitted from the transmitter 100 from a received signal, which may have been corrupted by the communication channel 12. Receiver 200 comprises a front end circuit 202, demodulator 204, de-interleaver 206, channel decoder 208, and source decoder 210.

Front end circuit 202 is coupled to a receive antenna. Front end circuit 202 converts the received signal to the baseband frequency to generate a baseband signal, which is then sampled and digitized. The sampled and digitized baseband signal is passed to the demodulator 204. The function of the demodulator 204 is to process the received signal to determine which of the possible symbols in the signal constellation were transmitted by the transmitter 100. For example, when binary modulation is used, the demodulator 204 processes the received signal and decides at each symbol interval whether a transmitted symbol is a "0" or a "1". The output of demodulator 204 is referred to herein as the received sequence, which is essentially an estimate of the transmit sequence. The received sequence will typically contain some bit errors.

De-interleaver 206 reorders the bits of the received sequence to undo the effects of interleaver 106, which are then input to the channel decoder 208. Channel decoder 208 attempts to detect and correct bit errors that may have occurred during transmission from the received sequence and it's *a priori* knowledge of the code used by the channel coder 104. A measure of how well the demodulator 204 and channel decoder 208 perform is the frequency with which bit errors occur in the decoded sequence.

As a final step, a source decoder 210 accepts the decoded output from the channel decoder 208 and, from knowledge of the source encoding method, attempts to reconstruct the original source data stream. The difference between the reconstructed source data stream and the original source data stream is a measure of the distortion introduced by the digital communication system 10.

In conventional digital communication systems 10, coding and modulation are performed separately at the transmitter 100. Likewise, demodulation and decoding are performed in separate operations at the receiver 200. The demodulator 204 decides what symbols were transmitted based on the received signal. The decisions by the demodulator 204 may be hard decisions or soft decisions that include reliability information. The channel decoder 208 then processes the decisions by the demodulator 204 using bit reliability information when available to detect and correct errors that may have occurred during transmission.

One commonly used modulation scheme is coherent phase shift keying (PSK). In coherent 8-PSK, each transmitted symbol Y(i) comprises three bits, denoted $y_1(i)$, $y_2(i)$, and $y_3(i)$. Each transmit symbol Y(i) maps to one point on the signal constellation. For example, each transmit symbol Y(i) may be mapped to the signal constellation using Gray coding, which means that all adjacent points on the signal constellation vary at only a single bit position. Coherent 8-PSK provides good performance in flat-fading channels with an adequate signal-to-noise ratio. However, receiver performance can suffer at low signal-to-noise ratios. This circumstance arises in time-varying channels where the phase of the signal is corrupted by, for example, Doppler effects and multipath propagation. In such cases, it may be desirable to employ a technique known as differential modulation.

Differential PSK (DPSK) is a non-coherent form of phase shift keying which avoids the need for a coherent reference signal at the receiver 200. Non-coherent receivers are relatively easy and inexpensive to build and, hence, are widely used in wireless communications. In DPSK systems, each symbol (grouping of bits) maps to a differential phase $\Delta\Phi$. The differential phase $\Delta\Phi$ is then used to determine the phase of the transmitted signal at symbol interval i according to the relation $\Phi_i = \Phi_{i-1} + \Delta\Phi_i$. Thus, in DPSK, the phase of each transmitted symbol $Y_1(i)$ is determined by the phase of the previously-transmitted symbol Y(i-1) and the differential phase $\Delta\Phi$. Thus, the received signal can be demodulated by comparing symbols only one symbol period apart, a sufficiently short time span so that channel phase changes insignificantly over that time period. Unfortunately, changing from coherent to differential modulation increases the number of certain error events and results in a loss of about 3 dB for all three bits.

One way to improve receiver performance is to combine demodulation and channel decoding using feedback from the channel decoder to the demodulator. This technique is referred to as multi-pass demodulation. In a multi-pass demodulation receiver, the received signal is initially demodulated and decoded in conventional fashion. The decoded bits are then re-encoded and selected ones of the re-encoded bits are fed back to the demodulator. The received signal is demodulated a second time. During the second pass through the demodulator, the re-encoded bits are treated as known bits or pilot bits by the demodulator. This process can be repeated multiple times, at the cost of increased complexity. Typically, the largest benefit occurs with the first few passes.

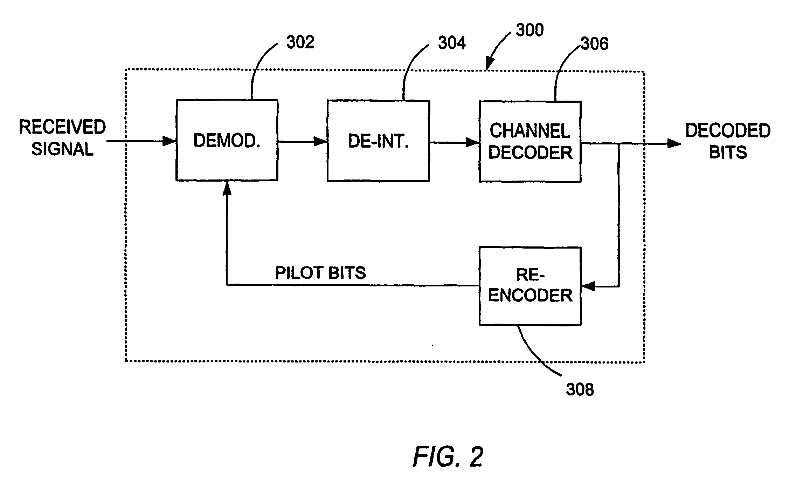

Figure 2 is a block diagram of a multi-pass demodulation receiver 300. Multi-pass demodulation receiver 300 comprises a demodulator 302, de-interleaver 304, channel decoder 306, and re-encoder 308. The received signal is converted to the baseband frequency and input to demodulator 203. During the first pass through the demodulator 302, the received signal is demodulated in a conventional fashion. The received sequence output from demodulator 302 is fed to de-interleaver 304, which reorders the bits of the received sequence. The output from de-interleaver 304 is fed to channel decoder 306, which detects and corrects errors that may have occurred during transmission. The output from channel decoder 306 is an estimate of the original information sequence transmitted from the transmitter 100. The output from channel decoder 306 is then re-encoded in re-encoder 308 and selected ones of the re-encoded bits are fed back to the demodulator 302 to use as pilot bits in second pass demodulation. During second pass demodulation, the re-encoded bits fed back from channel decoder 306 are treated as known bits by the demodulator 302. Thus, during second pass demodulation, the demodulator 302 is constrained to output symbols that meet the known bit pattern. The re-encoded bits output by channel decoder 306 may be "hard bits" or may be "soft bits" reflecting the level of confidence in the decision. In either case, well-known methods exist for exploiting the decisions in the demodulator 302.

Multi-pass demodulation may be particularly useful where the bits of a transmitted symbol have unequal error protection. The bits with the greatest error protection are decoded after the first pass through the demodulator 302 with a relatively high degree of certainty. The strongly coded bits may be treated as known bits in a second pass through the demodulator 302 to assist the demodulation of more weakly coded bits or unencoded bits. Demodulation in a multi-pass demodulation receiver 300 may involve two or more passes through the demodulator 302 with more bits treated as known bits after each pass through the demodulator 302. An example of a multi-pass receiver 300 is described in U. S. Patent No. 5,673,291 to Dent, which is incorporated herein by reference.

The present invention employs a technique referred to as differential coding in combination with higher order modulation to improve receiver performance. Error coding and interleaving may also be used. According to the present invention, a differential relation is established at the bit level between successive transmit symbols. The present invention is particularly suited to communication systems 10 with unequal error protection and diagonal interleaving, which are typically used for protecting speech. The invention is applicable to a wide range of communication protocols and technologies, including standards published by the Telecommunication Industry Association (TIA) and Electronics Industry Association (EIA) known as TIA/EIA-136, and the Bluetooth standard. Numerous variations of the differential coding scheme are possible, a few of which are described below to illustrate the flexibility afforded by differential coding.

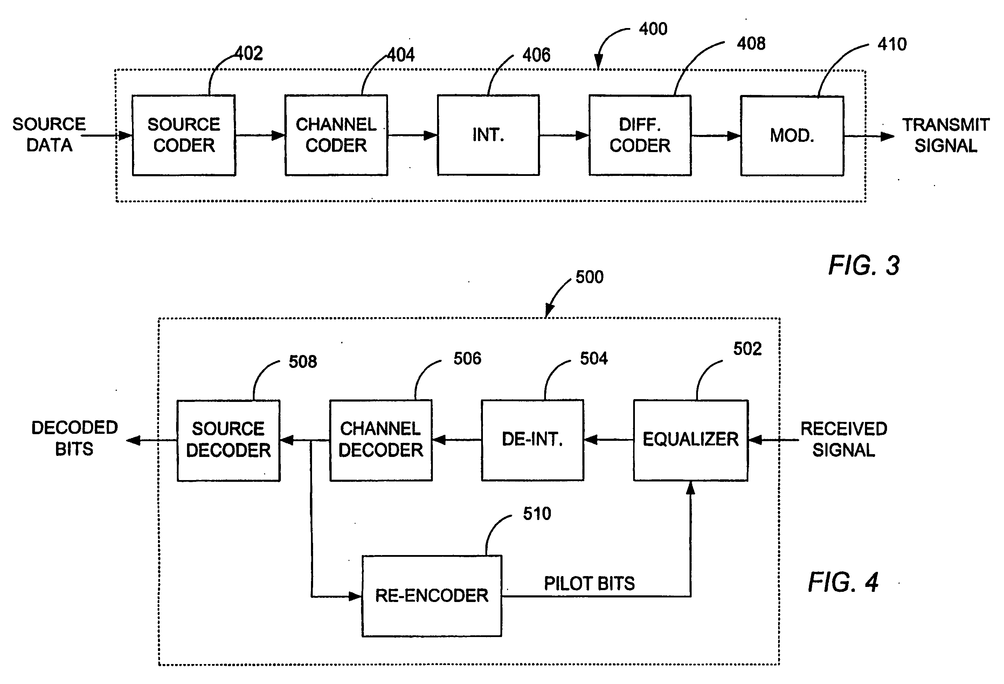

Figure 3 is a functional block diagram of a transmitter 400 according to the present invention that employs differential coding. The transmitter 400 is similar to a conventional transmitter 100 but includes a differential coder 408 to establish a differential relation between transmit symbols spaced in time. The transmitter 400 of the present invention comprises a source coder 402, channel coder 404, interleaver 406, differential coder 408, and modulator 410. Source coder 402, channel coder 404, and interleaver 406 perform the same functions as their counterparts in the conventional transmitter 100. It is to be noted that source coder 402, channel coder 404, and interleaver 406 are not essential elements of the inventive receiver 400 but one or more of these elements will typically be present.

In the illustrated embodiment of the invention, differential coder 408 receives the output from interleaver 406. Differential coder 408 could also receive output directly from channel coder 404 or source coder 402. In any case, differential coder 408 receives a bit sequence at its input, referred to herein as the input sequence, which is divided into successive symbols, referred to herein as input symbols. The function of the differential coder 408 is to produce a transmit sequence comprising a plurality of transmit symbols based on the input sequence by differentially coding selected bits of the input sequence. Differential coding may be performed, for example, by coding a selected bit of each input symbol with respect to one or more bits from one or more previous input symbols. In this example, the transmit sequence will comprise some bits which are differentially coded and others which are not differentially coded. It is not necessary that every transmit symbol include differentially coded bits. Some transmit symbols may be comprised entirely of differentially coded bits, while others contain no differentially encoded bits. Furthermore, some transmit symbols may comprise a mixture of differentially coded bits and non-differentially coded bits.

Modulator 410 receives the transmit sequence from differential coder 408 and modulates the transmit sequence onto a carrier. Modulator 410 may, for example, comprise a coherent 8-PSK modulator or a coherent 16-QAM modulator. However, those skilled in the art will recognize that the differential coding scheme may also be used with other higher order modulation schemes.

Referring now to Figure 4, a receiver 500, according to the present invention, is shown. Receiver 500 comprises an equalizer 502, de-interleaver 504, channel decoder 506, source decoder 508, and re-encoder 510. The de-interleaver 504, channel decoder 506, and source decoder 508 perform the same functions as their counterparts in receivers 200 and 300. These elements are not essential parts of the inventive receiver 500; however, one or more of these elements will typically be present. Similarly, re-encoder 510 performs the same function as its counterpart in receiver 300. Re-encoder 510 may advantageously be present when multi-pass demodulation is used, but it is not an essential element of the invention.

The function of equalizer 502 is to demodulate and differentially decode a received signal. In the illustrated embodiment, demodulation and differential decoding are performed jointly by equalizer 502. However, those skilled in the art will recognize that demodulation and decoding could be performed separately. That is, equalizer 502 could be replaced by a separate demodulator and differential decoder. In that case, the demodulator would output a received sequence comprising a plurality of received symbols which would then be fed to a differential decoder. The received sequence is, in essence, an estimate of the transmit sequence input to the modulator 410 at the transmitter 400. The differential decoder would, in that case, differentially decode the received sequence and generate an output sequence, which is essentially an estimate of the original input sequence to the differential coder 408 at the transmitter 400. However, an equalizer 502 can perform both operations, processing the received signal to generate the output sequence, without the intermediate step of generating a received sequence. Instead, differential decoding of the received sequence is performed by equalizer 502 jointly with demodulation.

Several examples of the differentially coding method of the present invention are given below. These examples assume that the same coding scheme is applied to each input symbol so that each transmit symbol in the transmit sequence comprises at least one differentially coded bit.

In the illustrations below, the modulation scheme employed is coherent 8-PSK. The transmit symbol, generally noted Y(i), maps directly to a point on the 8-PSK signal constellation. The transmit symbol Y(i) comprises three bits $y_1(i)$, $y_2(i)$, and $y_3(i)$. The transmit symbol Y(i) is derived from the input symbol, generally denoted X(i). As will be explained below, the bits of the transmit symbol Y(i) are differentially encoded.

## Example 1

In a first example, the transmit symbol Y(i) is derived from the input symbol X(i) as follows:

$$y_1(i)=x_1(i)$$

$$y_2(i)=x_2(i)+y_3(i-1)$$

$$y_3(i)=x_3(i) \qquad \text{Eq.1}$$

As shown in Equation 1, the bits $y_1$ and $y_3$ of the transmit symbol Y(i) are the same as the bits $x_1$ and $x_3$, respectfully, of the input symbol X(i), while bit $y_2$ is a differentially coded bit. That is, bit $y_2$ in the transmit symbol Y(i) is differentially coded with respect to bit $y_3$ from the previous transmit symbol, denoted as $y_3(i-1)$. Bit $x_2(i)$ of the transmit symbol may be a protected bit, or may be an unprotected bit. Similarly, bit $x_3$ of the previous input symbol X(i-1), which is used in the differential relation, may be a protected bit or an unprotected bit.

In a computer simulation performed by the inventor, the differential coding and modulation scheme of the present invention was compared to conventional coherent 8-PSK modulation. In particular, the simulation compared the Bit Error Rate (BER) vs. C/N performance of the inventive receiver 500 to a conventional receiver 200 employing coherent 8-PSK modulation. As expected, the bit error rate for bits $x_1$ and $x_3$ of the input symbol X(i) are the same as the corresponding bits in coherent 8-PSK modulation. The bit error rate for bit $x_2$ of the input symbol X(i) is more than double its counterpart in coherent 8-PSK. This increased bit error rate is due to the differential relation of bit $y_2$ of the transmit symbol Y(i) with respect to bit $y_3$ of the previous transmit symbol Y(I-1).

Multi-pass demodulation may be used to improve bit error performance at the cost of slightly greater receiver complexity. Assume that bits $x_1$ and $x_2$ are coded bits, and that bit $x_3$ is an uncoded bit. Further assume that bits $x_1$ and $x_2$ are fed back to the demodulator which produces a new estimate for $x_3$. Knowledge of $x_2$ improves the bit error rate of $x_3$. In the simulation, it was found that the bit error rate of $x_3$ following a second pass through the demodulator results in a 2 dB improvement in the bit error performance as compared to coherent 8-PSK modulation.

Example 2

In this example, the transmit symbol Y(i) is related to the input symbol X(i) as follows:

$$y_1(i)=x_1(i)$$

$$y_2(i)=x_2(i)+y_1(i-1)$$

$$y_3(i)=x_3(i) \qquad \text{Eq.2}$$

As shown in Equation 2, $y_1$ and $y_3$ of transmit symbol Y(i) are the same as bits $x_1$ and $x_3$, respectively, of input symbols X(i). However, bit $y_2$ of transmit symbol Y(i) is differentially coded with respect to bit $y_1(i-1)$ of the previous transmit symbol Y(i-1). In general, the bit error rate

for bit $y_1$ in 8-PSK modulation is less than the bit error rate for bit $y_3$. Consequently, the bit error rate for input bit $x_2$ is slightly improved as compared to the previous example, but still lower than conventional coherent 8-PSK modulation. The reduced performance is due to the differential relation. Again, multi-pass demodulation can be used to further improve performance. In second pass demodulation, input bits $x_2$ and $x_3$ are fed back and used as pilot bits to improve the bit error rate of input bit $x_1$ during second pass demodulation. The result is an improvement in the bit error rate for input bit $x_1$. The gain for input bit $x_1$ as compared to conventional coherent 8-PSK is about 4 dB. Additionally, it is noted that the bit error performance for input bits $x_2$ and $x_3$ are the same. This is beneficial since both of these bits are fed back to the decoder 506 and standard decoders expect bits of the same reliability.

Example 3

In this example, the transmit symbol Y(i) is related to the input symbol X(i) as follows:

$$y_1(i)=x_1(i)$$

$$y_2(i)=x_2(i)$$

$$y_3(i)=x_3(i)+y_2(i-1)+y_1(i-1) \qquad \text{Eq.3}$$

Bits $y_1$ and $y_2$ of the transmit symbol Y(i) are the same as bits $x_1$ and $x_2$ of the input symbol X(i). Bit $y_3$ of the transmit symbol is differential with respect to bits $y_2$ and $y_1$ from the previous transmit symbol Y(i-1). In the absence of multi-pass demodulation, the bit error performance for bits $x_1$ and $x_2$ following demodulation are the same as in coherent 8-PSK, while the bit error performance for bit $x_3$ is worse. Improved performance can be obtained using multi-pass demodulation. More particularly, bit $x_3$ may be fed back from decoder 506 to assist demodulation of bits $x_1$ and $x_2$ during second pass demodulation. In simulations performed by the inventor, an improvement of about 2 dB was realized in both bits $x_1$ and $x_2$ following second pass demodulation. The differential coding and modulation scheme illustrated by this example may be useful in situations where bit $x_3$ of input symbol X(i) is a protected bit, while bits $x_1$ and $x_2$ are either uncoded or have less error protection than bit $x_3$.

Example 4

In this example, the transmitted symbol Y(i) is related to the input symbol X(i) as follows:

$$y_1(i)=x_1(i)+y_2(i-1)$$

$$y_2(i)=x_2(i)+y_3(i-1)$$

$$y_3(i)=x_3(i) \qquad \text{Eq.4}$$

Bit $y_3$ of the transmit symbol Y(i) is identical to bit $x_3$ of the input symbol X(i). Bit $y_1$ of the transmit symbol Y(i) is differential with respect to bit $y_2$ from the previous transmit symbol Y(i-1) while bit $y_2$ is differential with respect to bit $y_3$ of the previous transmit symbol Y(i-1). After single pass demodulation, the bit error performance for bit $x_3$ is the same as conventional coherent 8-PSK. The bit error performance for bit $x_1$ is lower than coherent 8-PSK and is the same as the bit error performance of bit $x_2$ in Example 2. The bit error performance for bit $x_2$ is substantially below the bit error performance of the same bit using coherent 8-PSK without differential coding. Improved bit error performance can be obtained using multi-pass demodulation. More particularly, bit $x_1$ of transmit symbol X(i) may be fed back from decoder 506 to improve demodulation of bit $x_2$ during second pass demodulation. Alternatively, bit $x_1$ and bit $x_3$ of transmit symbol X(i) may both be fed back to improve the bit error performance of bit $x_2$ during second pass demodulation. In the first case, the improvement is small because bit $x_1$ is the "coherent" part of the differential relation as seen in Equation 4. In the second case, significant improvement in bit error performance for bit $x_2$ may be realized. The gain as compared to coherent 8-PSK is about 4.5 dB. As In the second example, bits $x_1$ and $x_3$ have the same reliability (i.e., bit error performance), which benefits decoding.

Example 5

In this example, the transmit symbol Y(i) is related to the input symbol X(i) as follows:

$$y_1(i)=x_1(i)$$

$$y_2(i)=x_2(i)+y_1(i-1)$$

$$y_3(i)=x_3(i)+y_1(i-1) \qquad \text{Eq.5}$$

Bit $y_1$ of the transmit symbol is identical to bit $x_1$ of the input symbol. Bits $y_2$ and $y_3$ of the transmit symbol are both differential with respect to bit $y_1$ of the previous transmit symbol Y(i-1). Following single path demodulation, the bit error performance for bit $x_1$ is the same as in coherent 8-PSK, while the bit error performance for bits $x_2$ and $x_3$ is lower due to the differential relation. The bit error performance for bit $x_2$ is the same as for bit $x_2$ in Example 2. The bit error performance for bit $x_3$ is slightly better than bit $x_3$ in Example 3, which is differential with respect to two bits instead of one in the present example. Again, improvements in bit error performance can be obtained by multi-pass demodulation. Using multi-pass demodulation, bit $x_2$ may be fed back to improve the bit error performance of bits $x_1$ and $x_3$. Alternately, bits $x_2$ and $x_3$ may be fed back to improve the bit error performance of bit $x_1$. In the first case, the improvement in bit error performance of bit $x_3$ is small since bit $x_3$ is only indirectly related to bit $x_2$. In the second case, there is an improvement in the bit error performance of bit $x_1$. The gain over coherent 8-PSK is about 5 dB.

In all of the above examples, equalizer 502 can be implemented as an eight state equalizer. It is assumed that coherent demodulation is used, where the channel is estimated and used in the demodulation process. Channel estimation is well known to those skilled in the art and is not addressed further in the present application.

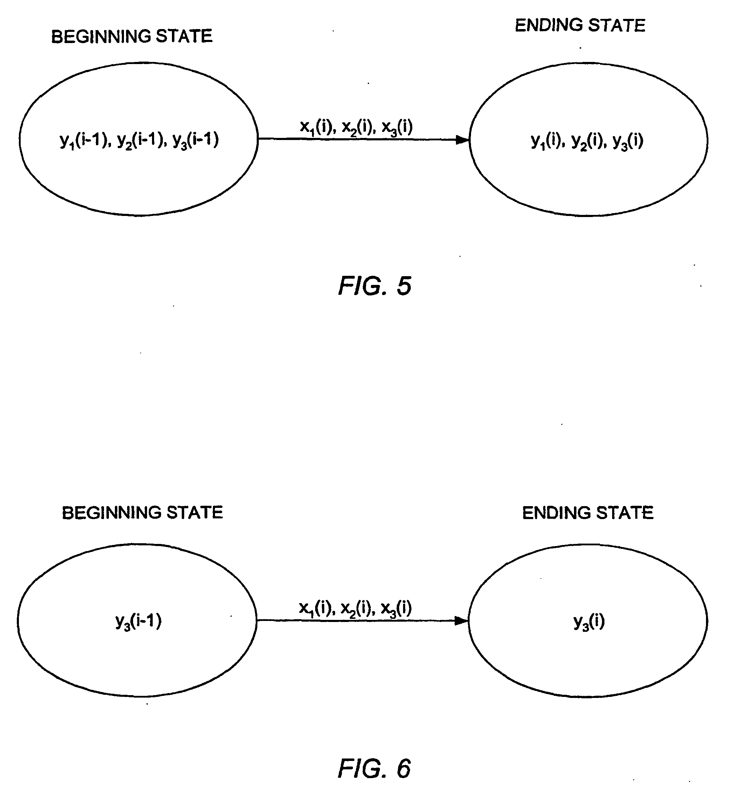

Figure 5 is a diagram of an eight-state equalizer trellis that may be used by equalizer 502. The states represent possible values for the transmit symbol Y(n). The transitions are associated with an input symbol X(n) that causes the transition from one state to the next state. The values of the input symbol X(n) that cause the transition are determined by the differential relation. For example, in an equalizer 502 that implements Example 1, the value of the transitions is determined by the following relation which is derived from Equation 1:

$$x_1(i)=y_1(i)$$

$$x_2(i)=y_2(i)+y_3(i-1)$$

$$x_3(i)=y_3(i) \qquad \text{Eq.6}$$

Examples 1-6 can all be handled by the same eight-state equalizer 502 with Equation 6 above replaced by the appropriate relation for Examples 2-5. In all cases, there is a transition from each of the eight possible beginning states $Y_1(i-1)$ to each of the eight possible ending states $Y_1(i)$. Given this trellis, demodulation and decoding can be carried out using the Viterbi algorithm or MAP algorithm, both of which are well known in the art.

In the case of coherent 8-PSK, the demodulator does not need a state for each possible value of the transmit symbol X(i) since modulation is memoryless in the absence of dispersion. Thus, the eight states can be collapsed into a single state. The same approach can be taken with the differential coding and modulation schemes of the present invention. For a non-dispersive channel, where knowledge of all eight states is not necessary, it is possible to reduce the number of states, provided the differential relation is taken into account. In the first example, it can be seen from Equation 1 that the equalizer 502 needs to have a state for bit $y_3$ only, so the eight states can be collapsed into two states representing the possible values of $y_3$. In the second exam-

ple, Equation 2 indicates that the eight states can be collapsed into two states representing $y_3$. In the third example, Equation 3 shows that the eight states can be collapsed to four states representing all possible combinations of $y_1$ and $y_2$. In Example 4, Equation 4 indicates that the eight states can be collapsed into four states representing possible combinations of $y_2$ and $y_3$. Finally, in the last example, Equation 5 indicates that the eight states can be collapsed into two states representing $y_1$.

Figure 6 is a diagram illustrating a two-state trellis corresponding to Example 1. There are two possible values for the beginning state $y_3(i-1)$ and two possible values for the ending state $y_3(i)$. There are four transitions from each of the two beginning states $y_3(i-1)$ to each of the two ending states $y_3(i)$. The four transitions account for the four possible combinations of $y_1(i)$ and $y_2(i)$. Reduced-size trellises corresponding to Examples 2-5 can be devised in similar fashion.

It is always possible to use an eight-state equalizer for demodulation and decoding, even though a lesser number of states would suffice. The redundant states do not hurt bit error performance but would require additional computations and memory without providing any advantage. It is to be noted, however, that if a receiver 500 is designed to handle a number of different differential coding schemes, it may be advantageous to always use the same eight state equalizer 502, which can be built as an efficient hardware circuit, for instance. More generally, the equalizer trellis needs to have the number of states required to fully represent the relations defined by the differential coding. Thus, if all three bits from a previous transmit symbol Y(i-1) are used in differential relations for a current transmit symbol Y(i), then the equalizer 502 needs to have eight states. Similarly, if the differential relations involve all three bits of the previous transmit symbol, as well as three bits from the transmit symbol two periods before the current symbol, then the equalizer 502 needs to have sixty-four states.

So far, it has been assumed that the communication channel is a flat, fading channel, which can be represented by a single channel tap in the equalizer 502. In the case of dispersive channels, an equalizer 502 is required to take dispersion into account. Fortunately, the same equalizer 502 that handles differential decoding is also capable of handling channel dispersion. The eight-state equalizer 502 described above can handle a two-tap symbol- spaced dispersive channel. A sixty-four-state equalizer 502 can handle a three-tap channel, and so on. It should also be noted that differential coding and channel dispersion can share states. In other words, the memory they introduce does not necessarily add. In contrast, the memory due to a partial response modulation scheme and a dispersive channel adds, so that the equalizer state space needs to grow to handle both.

The differential coding method can also be used with other higher-order modulation schemes. The following examples illustrate the use of the differential coding scheme of the present invention, in combination with 16-quadrature amplitude modulation (QAM). In standard coherent 16-QAM, the transmit symbol Y(i) comprises four bits $y_1(i)$, $y_2(i)$, $y_3(i)$, $y_4(i)$ which map directly to a point on the signal constellation. In the following discussion, it is assumed that Gray code mapping is used. When Gray code mapping is used, bits $x_1(i)$ and $x_3(i)$ have the same performance. Bits $x_2(i)$ and $x_4(i)$ exhibit worst performance by a factor slightly less than two. Bits $x_1$ and $x_3$ are referred to as the "good" bits and bits $x_2$ and $x_4$ are referred to as the "bad" bits. For each of the examples given below, the BER versus C/N performance in a flat Rayleigh-fitting channel was simulated.

### Example 6

In this example, the transmit symbol Y(i) is derived from the input symbol X(i) as follows:

$$y_1(i)=x_1(i)$$

$$y_2(i)=x_2(i)+y_1(i-1)$$

$$y_3(i)=x_3(i)$$

$$y_4(i)=x_4(i)+y_3(i-1) \qquad \text{Eq.7}$$

In this example, bits $y_1$ and $y_3$ of the transmit symbol Y(i) are the same as in coherent 16-QAM. Bits $y_2$ and $y_4$ of the transmit symbol Y(i) are differential with respect to the first bit and the third bit of the previous transmit symbol, denoted $y_1(i-1)$, respectively. The bit error performance for bits $x_1$ and $x_3$ of the input symbol X(i) are the same as in coherent 16-QAM. In second pass demodulation, bits $x_2$ and $x_4$ of the input symbol X(i) are fed back to the equalizer 502 and used as pilots to assist demodulation of bits $x_1$ and $x_3$. The gain for bits $x_1$ and $x_3$ as compared to the same bits for 16-QAM is about 2 dB. Note that bits $x_2$ and $x_4$, which are fed back and used as pilot bits, have the same bit error performance. As previously described, this is beneficial for decoding since standard decoders expect bits of the same reliability.

### Example 7

In this example, the transmit symbol Y(i) is derived from the input symbol X(i) as follows:

$$y_1(i)=x_1(i)$$

$$y_2(i)=x_2(i)$$

$$y_3(i)=x_3(i)+y_1(i-1)$$

$$Y_4(i)=x_4(i) \qquad \text{Eq.8}$$

In this example, bits $y_1$ and $y_3$ of the transmit symbol Y(i) are the same as in coherent 16-QAM. Bits $y_2$ and $y_4$ of the transmit symbol Y(i) are differential with respect to the first bit and the third bit of the previous transmit symbol, denoted $y_1(i-1)$, respectively. The bit error performance for bits $x_1$, $x_2$, and $x_4$ are the same as in coherent 16-QAM after first pass demodulation. Some improvement can be obtained by multi-pass demodulation. In particular, bit $x_3$ may be fed back to equalizer 502 and used as a pilot bit to assist demodulation of bit $x_1$. In this case, the bit error performance for bit $x_1$ is improved over coherent 16-QAM by about 4 dB. There is no improvement in the bit error performance of bits $x_2$ and $x_4$.

Example 8

In this example, the transmit symbol Y(i) is derived from the input X(i) as follows:

$$y_1(i)=x_1(i)$$

$$y_2(i)=x_2(i)+y_1(i-1)$$

$$y_3(i)=x_3(i)+y_1(i-1)$$

$$y_4(i)=x_4(i)+y_1(i-1) \qquad \text{Eq.9}$$

Bit $y_1(i)$ of the transmit symbol Y(i) is the same as bit $x_1(i)$ of the input symbol X(i). Bits $y_2$, $y_3$, and $y_4$ of the transmit symbol Y(i) are differential with respect to bit $y_1$ of the previous transmit symbol. Following first pass demodulation, the bit error performance for bit $x_1$ is the same as in coherent 16-QAM. The performance of bits $x_2$, $x_3$, and $x_4$ is less favorable than coherent 16-QAM. In second pass demodulation, bits $x_2$, $x_3$, and $x_4$ may be fed back and used as pilot bits to assist demodulation of bit $x_1$. In this case, the improvement in bit error performance of bit $x_1$ is about 5 dB as compared to coherent 16-QAM.

A number of examples of the differential coding method of the present invention have been given showing the differential coding method used in connection with 8-PSK and 16-QAM modulation. Those skilled in the art will appreciate that the differential coding method of the present invention may also be used with other higher-order modulation techniques.

The differential coding and modulation scheme presented here is particularly well suited for a communication system 10 with unequal error protection. For example, consider a system with a set of strongly-coded bits, a set of weakly-coded bits, and a set of unencoded bits. Further assume that multi-pass demodulation is used. Following first pass demodulation, the strongly-coded bits are decoded and fed back from the decoder 506 to help demodulate the weakly-coded bits in second pass demodulation. Following second pass demodulation, the weakly-coded bits are decoded and fed back, along with the strongly-coded bits, to assist demodulation of the unencoded bits. In each pass, the differential coding helps spread the effect of coding to other bits, improving bit error performance.

Another situation where differential coding and multi-pass demodulation are useful is in communication systems 10 that employ diagonal interleaving. In the simplest case of diagonal interleaving, a frame of data at the output of an encoder is split equally among two bursts transmitted over a channel. Each burst contains equal amounts of data from two consecutive frames. At the receiver 500, when one burst is demodulated, half of the demodulated output is used to complete the set of data required to decode one frame and the other half is stored, awaiting the next burst. When a frame is decoded and fed back to the equalizer 502 for second pass demodulation, the half frame which is stored is improved. Thus, differential coding and multi-pass demodulation benefit a communication system 10 with diagonal interleaving, even in the absence of unequal error protection. More general forms of diagonal interleaving exist, involving multiple frames and multiple bursts, but the same principle holds for them as well.

When designing systems using differential coding and multi-pass demodulation, placement of pilot bits and non-pilot bits within a symbol must be considered. In the above examples, the same bit or bits within each symbol serve as pilots, which are fed back to assist in second pass demodulation. It is also possible to have symbols with different pilot assignments within a single burst. One simple case is where some symbols consist exclusively of pilots, and other symbols contain a mix of pilots and non-pilot bits. This asymmetric approach may be useful, for instance, in order to accommodate encoded and unencoded bits in a burst when their numbers do not easily fit into a consistent assignment scheme. Another simple case is where some symbols consist exclusively of non-pilots because pilot bits have been exhausted. In general, it is possible to use a variable number of pilot bits per symbol, as well as a variable differential coding relation.

**Claims**

1. A method of coding/decoding information for transmission over a communication channel, **characterised in that** said method comprising the steps of:

   differentially encoding a first bitstream with respect to a second bitstream to establish a differential relation at bit level between successive transmit symbols, wherein the first and second bitstreams have unequal error protection;

generating transmit symbols by combining bits from the first and second bitstreams, wherein said generating comprises generating modulation symbols from two or more bits from the first and second bitstreams, the method further comprising the steps of receiving demodulating and decoding a sequence of the transmit symbols,

decoding recovered bits from the received sequence of transmit symbols in a first pass to recover non-differentially encoded bits from the received sequence;

decoding recovered bits from the received sequence of the transmit symbols in a second pass using the non-differentially encoded bits from the first pass as known bits in the second pass to improve the decoding of the differentially encoded bits, channel decoding the recovered bits and

feeding back re-encoded bits from a channel decoder for use as pilot bits in demodulating the received sequence of the transmit symbols.

2. The method of claim 1, wherein the first bitstream has a lower error protection than the second bitstream, such that differentially encoding the first bitstream with respect to the second stream improves the ability of a receiver to recover decoded bits associated with the first bitstream from decoded transmit symbols at the receiver.

3. The method of claim 1, wherein differentially encoding a first bitstream with respect to a second bitstream comprises differentially encoding selected bits in the first bitstream such that the transmit symbols include differentially encoded bits and non-differentially encoded bits.

4. The method of claim 3, further comprising determining whether to selectively apply differential encoding to the first bitstream based on a relative error protection difference between the error protections applied to the bits comprising the first and second bitstreams.

5. The method of claim 1, wherein the first and second bitstreams are formed by grouping bits in a common bitstream in successive groups, and forming the first bitstream as successive bits from a first bit position within the successive bit groups, and forming the second bitstream as successive bits from a second bit position within the successive bit groups.

6. The method of claim 5, wherein each bit group corresponds to one of the transmit symbols, and wherein differentially encoding the first bitstream with respect to the second bitstream comprises differentially encoding bits from the first bitstream corresponding to given transmit symbols with bits from the second bitstream corresponding to different transmit symbols.

7. The method of claim 6, wherein demodulating and decoding the received sequence of the transmit symbols are performed jointly in an equalizer.

8. The method of claim 6, further comprising re-encoding selected channel decoded bits from the channel decoder to produce the re-encoded bits.

9. The method of claim 6, wherein the non-differentially encoded bits include bits from the second bitstream used in generating the transmit symbols, such that a stronger error encoding of the second bitstream relative to the first bitstream improves decoding of the differentially encoded bits, which include bits from the first bitstream

10. An apparatus (300) to receive a sequence of transmit symbols formed by differentially encoded bits in a first bitstream with respect to bits in a second bitstream with a differential relation at bit level between successive transmit symbols, wherein the first and second bitstreams have unequal error protection, the apparatus comprising:

a demodulator (302) to generate recovered bits by demodulating the received sequence of transmit symbols;

a decoder (306) to generate in a first pass decoded bits by differentially decoding recovered bits corresponding to the second bitstream; and a channel decoder (308) to generate channel decoded bits corresponding to the second bitstream are fed back re-encoded as pilot bits to the demodulator in a second pass to improve demodulation of the recovered bits.

11. The apparatus of claim 10, wherein the demodulator and decoder are implemented jointly as an equalizer, such that demodulation and decoding are performed jointly.

**Patentansprüche**

1. Ein Verfahren zum Codieren/Decodieren von Information zur Übertragung über einen Kommunikationskanal, **dadurch gekennzeichnet, dass** das Verfahren die Schritte umfasst:

Differential-Codieren eines ersten Bit-Stroms bezüglich eines zweiten Bit-Stroms zum Etablieren eines Differentialverhältnisses bei einem Bit-Niveau zwischen aufeinanderfolgenden Sendezeichen, wobei der erste und zweite Bit-Strom eine ungleiche Fehlersicherung aufweisen;

Erzeugen von Sendezeichen durch Kombinieren von Bits von dem ersten und zweiten Bit-Strom, wobei das Erzeugen ein Erzeugen von Modulationszeichen von zwei oder mehreren Bits von dem ersten und zweiten Bit-Strom umfasst, und das Verfahren ferner die Schritte umfasst, Empfangen eines Demodulierens und Decodierens einer Sequenz der Sendezeichen, Decodieren von wiedergewonnenen Bits von der empfangenen Sequenz der Sendezeichen in einem ersten Durchgang zum Wiedergewinnen nicht-differentialcodierter Bits von der empfangenen Sequenz;

Decodieren von wiedergewonnenen Bits von der empfangenen Sequenz der Sendezeichen in einem zweiten Durchgang unter Verwendung der nicht-differential-codierten Bits von dem ersten Durchgang als bekannte Bits in dem zweiten Durchgang zum Verbessern des Decodierens der differential-codierten Bits, Kanaldecodieren der wiedergewonnenen Bits und

Zurückführen der wiedercodierten Bits von einem Kanaldecodierer zur Verwendung als Pilot-Bits bzw. Leit-Bits beim Demodulieren der empfangenen Sequenz der Sendezeichen.

2. Das Verfahren nach Anspruch 1, wobei der erste Bit-Strom eine geringere Fehlersicherung aufweist als der zweite Bit-Strom, so dass Differential-Codieren des ersten Bit-Stroms bezüglich des zweiten Stroms die Fähigkeit eines Empfängers verbessert, decodierte Bits wiederzugewinnen, die mit dem ersten Bit-Strom von decodierten Sendezeichen beim Empfänger in Zusammenhang stehen.

3. Das Verfahren nach Anspruch 1, wobei Differential-Codieren eines ersten Bit-Stroms bezüglich eines zweiten Bit-Stroms ein Differential-Codieren ausgewählter Bits in dem ersten Bit-Strom umfasst, so dass die Sendezeichen differential-codierte Bits und nicht-differential-codierte Bits enthalten.

4. Das Verfahren nach Anspruch 3, ferner umfassend, Bestimmen, ob selektives Differential-Codieren auf den ersten Bit-Strom angewendet werden soll, basierend auf einem relativen Fehlersicherungsunterschied zwischen den Fehlersicherungen, die für die Bits umfassend den ersten und zweiten Bit-Strom angewendet werden.

5. Das Verfahren nach Anspruch 1, wobei der erste und zweite Bit-Strom gebildet werden durch Gruppieren von Bits in einem gemeinsamen Bit-Strom in aufeinanderfolgenden Gruppen und Bilden des ersten Bit-Stroms als aufeinanderfolgende Bits von einer ersten Bit-Position innerhalb der aufeinanderfolgenden Bit-Gruppen, und Bilden des zweiten Bit-Stroms als aufeinanderfolgende Bits von einer zweiten Bit-Position innerhalb der aufeinanderfolgenden Bit-Gruppen.

6. Das Verfahren nach Anspruch 5, wobei jede Bit-Gruppe einem der Sendezeichen entspricht, und wobei Differential-Codieren des ersten Bit-Stroms bezüglich des zweiten Bit-Stroms Differential-Codieren von Bits von dem ersten Bit-Strom entsprechend gegebener Sendezeichen mit Bits von dem zweiten Bit-Strom entsprechend verschiedener Sendezeichen umfasst.

7. Das Verfahren nach Anspruch 6, wobei ein Demodulieren und Decodieren der empfangenen Sequenz der Sendezeichen zusammen in einem Entzerrer ausgeführt wird.

8. Das Verfahren nach Anspruch 6, ferner umfassend ein Wiedercodieren ausgewählter kanaldecodierter Bits von dem Kanaldecodierer zum Erzeugen der wiedercodierten Bits.

9. Das Verfahren nach Anspruch 6, wobei die nicht-differential-codierten Bits Bits von dem zweiten Bit-Strom enthalten, der beim Erzeugen der Sendezeichen verwendet wird, so dass eine stärkere Fehlercodierung des zweiten Bit-Stroms relativ zu dem ersten Bit-Strom ein Decodieren der differential-codierten Bits verbessert, die Bits von dem ersten Bit-Strom enthalten.

10. Eine Vorrichtung (300) zum Empfangen einer Sequenz von Sendezeichen, gebildet durch differential-codierte Bits in einem ersten Bit-Strom bezüglich Bits in einem zweiten Bit-Strom mit einem Differentialverhältnis bei einem Bit-Niveau zwischen aufeinanderfolgenden Sendezeichen, wobei der erste und zweite Bit-Strom eine ungleiche Fehlersicherung aufweisen, und die Vorrichtung umfasst:

einen Demodulator (302) zum Erzeugen wiedergewonnener Bits durch Demodulieren der empfangenen Sequenz der Sendezeichen;
einen Decodierer (306) zum Erzeugen decodierter Bits in einem ersten Durchgang durch Differential-Codieren wiedergewonnener Bits entsprechend zu dem zweiten Bit-Strom; und ein Kanaldecodierer (308) zum Erzeugen von kanaldecodierten Bits entsprechend zu dem zweiten Bit-Strom als Pilot-Bits, wiedercodiert, und zu dem Demodulator in einem zweiten Durchgang zurückgekoppelt zum Verbessern einer Demodulation der wiedergewonnenen Bits.

**11.** Die Vorrichtung nach Anspruch 10, wobei der Demodulator und Decodierer gemeinsam als ein Entzerrer implementiert sind, so dass eine Demodulation und Decodierung gemeinsam ausgeführt werden.

## Revendications

**1.** Procédé de codage/décodage d'informations pour une transmission sur une voie de communication, **caractérisée en ce que** ledit procédé comprend les étapes consistant à :

coder de façon différentielle un premier flot binaire (bitstream) par rapport à un deuxième flot binaire pour établir une relation différentielle au niveau de bit entre des symboles de transmission successifs, dans lequel les premier et deuxième flots binaires possèdent une protection d'erreurs inégale ;

produire des symboles de transmission en combinant des bits en provenance des premier et deuxième flots binaires, dans lequel ladite production comporte une production de symboles de modulation à partir de deux bits ou plus depuis les premier et deuxième flots binaires, le procédé comprenant de plus les étapes de réception, de démodulation et de décodage d'une séquence de symboles de transmission ;

décoder des bits récupérés à partir de la séquence reçue de symboles de transmission dans un premier passage pour récupérer des bits codés de façon non différentielle à partir de la séquence reçue ;

décoder des bits récupérés à partir de la séquence reçue des symboles de transmission dans un deuxième passage en utilisant des bits codés de façon non différentielle à partir du premier passage en tant que bits connus dans le deuxième passage pour améliorer le décodage des bits codés de façon différentielle ;

effectuer un décodage de canal sur les bits récupérés et

réinjecter des bits recodés à partir d'un décodeur de canal pour une utilisation en tant que bits pilotes dans une démodulation de la séquence reçue des symboles de transmission.

**2.** Procédé selon la revendication 1, dans lequel le premier flot binaire possède une protection d'erreurs inférieure au deuxième flot binaire, de sorte qu'un codage effectué de façon différentielle du premier flot binaire par rapport au deuxième flot améliore la capacité d'un récepteur de récupérer des bits décodés associés avec le premier flot binaire à partir de symboles de transmission décodés au niveau du récepteur.

**3.** Procédé selon la revendication 1, dans lequel un codage de façon différentielle d'un premier flot binaire par rapport à un deuxième flot binaire comporte des bits sélectionnés à codage différentiel dans le premier flot binaire de sorte que les symboles de transmission comportent des bits codés de façon différentielle et des bits codés de façon non différentielle.

**4.** Procédé selon la revendication 3, comprenant de plus une détermination si l'on doit appliquer de façon sélective un codage différentiel au premier flot binaire sur la base d'une différence de protection d'erreurs relative entre les protections d'erreurs appliquées aux bits comportant les premier et deuxième flots binaires.

**5.** Procédé selon la revendication 1, dans lequel les premier et deuxième flots binaires sont formés en groupant des bits dans un flot binaire commun dans des groupes successifs, et en formant le premier flot binaire en tant que bits successifs à partir d'une première position de bit au sein des groupes de bits successifs, et en formant le deuxième flot binaire en tant que bits successifs à partir d'une deuxième position de bit au sein des groupes de bits successifs.

**6.** Procédé selon la revendication 5, dans lequel chaque groupe de bits correspond à l'un des symboles de transmission, et dans lequel un codage effectué de façon différentielle du premier flot binaire par rapport au deuxième flot binaire comporte des bits à codage différentiel en provenance du premier flot binaire correspondant à des symboles de transmission donnés avec des bits en provenance du deuxième flot binaire correspondant à des symboles de transmission différents.

**7.** Procédé selon la revendication 6, dans lequel une démodulation et un décodage de la séquence reçue des symboles de transmission sont effectués conjointement dans un égaliseur.

**8.** Procédé selon la revendication 6, comprenant de plus un recodage des bits décodés en canal sélectionnés à partir du décodeur de canal pour produire les bits recodés.

**9.** Procédé selon la revendication 6, dans lequel les bits codés de façon non différentielle comportent des bits en provenance du deuxième flot binaire utilisés dans la production des symboles de transmission, de sorte qu'un codage d'erreurs plus fort du deuxième flot binaire par rapport au premier flot binaire améliore le décodage des bits codés de façon différentielle qui comportent des bits en provenance du premier flot binaire.

10. Dispositif (300) destiné à recevoir une séquence de symboles de transmission formés par des bits codés de façon différentielle dans un premier flot binaire par rapport à des bits dans un deuxième flot binaire avec une relation différentielle au niveau de bit entre des symboles de transmission successifs dans lequel les premier et deuxième flots binaires possèdent des protections d'erreurs inégales, le dispositif comprenant :

   un démodulateur (302) servant à produire des bits récupérés par une démodulation de la séquence reçue de symboles de transmission ; un décodeur (306) servant à produire dans un premier passage des bits décodés en décodant de façon différentielle des bits récupérés correspondant au deuxième flot binaire ; et un décodeur (308) de canal servant à produire des bits de canal décodés correspondant au deuxième flot binaire qui sont recodés en tant que bits pilotes et réinjectés au démodulateur dans un deuxième passage pour améliorer une démodulation des bits récupérés.

11. Dispositif selon la revendication 10, dans lequel le démodulateur et le décodeur sont mis en oeuvre conjointement en tant qu'égaliseur, de sorte qu'une démodulation et un décodage soient effectués conjointement.

FIG. 1

*FIG. 2*

EP 1 262 027 B1

EP 1 262 027 B1

402 404 406 400 408 410

SOURCE DATA → SOURCE CODER → CHANNEL CODER → INT. → DIFF. CODER → MOD. → TRANSMIT SIGNAL

*FIG. 3*

500

508 506 504 502

DECODED BITS ← SOURCE DECODER ← CHANNEL DECODER ← DE-INT. ← EQUALIZER ← RECEIVED SIGNAL

510

RE-ENCODER — PILOT BITS

*FIG. 4*

BEGINNING STATE

ENDING STATE

$y_1(i-1), y_2(i-1), y_3(i-1)$

$x_1(i), x_2(i), x_3(i)$

$y_1(i), y_2(i), y_3(i)$

*FIG. 5*

BEGINNING STATE

ENDING STATE

$y_3(i-1)$

$x_1(i), x_2(i), x_3(i)$

$y_3(i)$

*FIG. 6*